# EUROPÄISCHE PATENTSCHRIFT

(11) **EP 3 028 023 B1**
(45) Veröffentlichungstag und Bekanntmachung des Hinweises auf die Patenterteilung: **09.08.2017**
(21) Anmeldenummer: 14730076.8
(22) Anmeldetag: 04.06.2014
(51) Int. Cl.: G01G 3/14, G01L 25/00, G01R 3/00, G01L 1/04, G01L 1/22

(54) **VERFAHREN ZUR FERTIGUNG EINES KRAFTMESSKÖRPERS**
METHOD FOR PRODUCING A FORCE-MEASURING ELEMENT
PROCÉDÉ DE FABRICATION D'UN ÉLÉMENT DE MESURE DE FORCE

(30) Priorität: 29.07.2013 DE 102013108097
(43) Veröffentlichungstag der Anmeldung: 08.06.2016
(73) Patentinhaber: Sartorius Lab Instruments GmbH & Co. KG, 37079 Göttingen (DE)
(72) Erfinder: GRAF, Winfried, 37127 Niemetal (DE); HELMSEN, Friedrich, 37073 Göttingen (DE); ERBEN, Detlev, 37078 Göttingen (DE); COVIC, Helga, 37083 Göttingen (DE); MÜCK, Tanja, 38685 Langelsheim (DE)
(86) Internationale Anmeldenummer: PCT/EP2014/001508
(87) Internationale Veröffentlichungsnummer: WO 2015/014420

(56) Entgegenhaltungen:
- EP-A2- 0 164 862
- WO-A1-2008/145426
- DE-A1- 10 229 016
- US-A- 3 968 683

## Beschreibung

### Gebiet der Erfindung

Die Erfindung bezieht sich auf ein Verfahren zur Fertigung eines Kraftmesskörpers mit mindestens einer Gelenkstelle, die einen Bereich des Kraftmesskörpers in zwei zueinander auslenkbare, verbundene Teilbereiche separiert, wobei folgende Schritte ausgeführt werden:
- Bereitstellen eines Kraftmesskörper-Rohlings,
- Materialabtrag am Kraftmesskörper-Rohling zur Herstellung der Gelenkstelle,
- Überprüfung, ob das durch die Gelenkstelle erzeugte Auslenkungsverhalten der Teilbereiche einer vorgegebenen Spezifikation entspricht,
- Bestimmung einer mittels Materialabtrags herstellbaren Korrekturform, die eine ermittelte Abweichung von der vorgegebenen Spezifikation ausgleicht,
- Korrektur der Gelenkstellengeometrie anhand der im vorigen Verfahrensschritt bestimmten Korrekturform mittels Materialabtrag.

Die Erfindung bezieht sich weiter auf einen Kraftmesskörper mit mindestens einer Gelenkstelle, die einen Bereich des Kraftmesskörpers in zwei zueinander auslenkbare, verbundene Teilbereiche separiert, wobei die Gelenkstelle eine Korrekturstelle aufweist.

### Stand der Technik

Ein Verfahren zur Fertigung eines Kraftmesskörpers mit mindestens einer Gelenkstelle, die einen Bereich des Kraftmesskörpers in zwei zueinander auslenkbare, verbundene Teilbereiche separiert, ist bekannt. In einem ersten Schritt wird Material eines Kraftmesskörper-Rohlings abgetragen, sodass dieser in zwei, zueinander auslenkbare Teilbereiche separiert wird. In einem nächsten Verfahrensschritt wird überprüft, ob das durch die Gelenkstelle erzeugte Auslenkungsverhalten der Teilbereiche einer vorgegebenen Spezifikation entspricht. Der Begriff des Auslenkungsverhaltens ist hierbei weit zu verstehen und umfasst insbesondere die Aspekte der Beweglichkeit der Gelenkstelle, der Auslenkungsrichtung der aneinander angelenkten Teilbereiche und die exakte Position des Drehpunktes. Eine hierzu gemessene Abweichung wird in einem nächsten Verfahrensschritt entsprechend korrigiert, indem Material an der Gelenkstelle spanend, beispielsweise mittels einer Feile, abgetragen wird. Dieser Materialabtrag wird hierbei vorzugsweise (maschinell möglich) per Hand durch einen geschulten Fachmann getätigt.

Nachteilig bei diesem Verfahren ist, dass in der Regel eine solche Gelenkstellenkorrektur die gemessene Abweichung nicht vollständig aufhebt. Zudem wird durch den spanenden Materialabtrag eine Kraft auf die Gelenkstelle ausgeübt, welche eine ungewollte plastische Verformung des durch die Gelenkstelle entstandenen Biegekörpers oder Spannungen in dem Material der Gelenkstelle verursachen kann. Ferner offenbart WO 2008/145426 A1 eine justierbare Parallelführung insbesondere für ein gravimetrisches Messinstrument, wodurch sich Ecklastenfehler der Parallelführung korrigieren lassen.

US 3 968 683 A offenbart ebenfalls ein Verfahren zur Ecklastenkorrektur bei einem Wägeinstrument, allerdings durch Einsatz eines Lasers zur Materialbearbeitung.

EP 0 164 862 A2 offenbart eine Wägezelle basierend auf Dehnmessstreifen, welche mittels Laserbearbeitung justiert werden.

DE 102 29 016 A1 offenbart ein Schwenklager, insbesondere zur Lagerung für Wägebrücken, welches aus dem Grundkörper mittels Laserbearbeitung herausgebildet wird.

### Aufgabenstellung

Es ist die Aufgabe der vorliegenden Erfindung, die Korrektur der Gelenkstellengeometrie bei der Fertigung einer Kraftmessvorrichtung so zu verbessern, dass diese kräftefrei, reproduzierbarer, präziser und schneller durchführbar ist, sowie einen entsprechenden Kraftmesskörper zur Verfügung zu stellen.

### Darlegung der Erfindung

Diese Aufgabe wird in Verbindung mit den Merkmalen des Oberbegriffs von Anspruch 1 dadurch gelöst, dass der Materialabtrag zur Korrektur der Gelenkstellengeometrie mittels eines Lasers erfolgt.

Bevorzugte Ausführungsformen sind Gegenstand der abhängigen Ansprüche.

Die Korrektur der Gelenkstellengeometrie ist dann nötig, wenn das durch die Gelenkstelle erzeugte Auslenkungsverhalten der Teilbereiche einer vorgegebenen Spezifikation nicht entspricht. Dies ist z.B. dann der Fall, wenn die Auslenkungsrichtung der durch die Gelenkstelle entstandenen, zueinander auslenkbaren Teilbereiche des Kraftmesskörpers nicht senkrecht zu einer Biegeebene der Gelenkstelle liegt oder wenn dieser Teilbereich bei der Auslenkung durch eine äußere Krafteinwirkung einen Drall erfährt. Solche Fehler können dann auftreten, wenn der Materialabtrag bei der Herstellung einer Gelenkstelle nicht gleichmäßig ist, so dass die Gelenkstelle an einer Stelle einen Materialüberschuss oder eine Erhöhung aufweist.

Durch das erfindungsgemäße Verfahren ist ein sehr präziser Materialabtrag in einer Größenordnung von wenigen Mikrometern möglich. So kann ein Fehler aufgrund von außermittiger Belastung mittels Laserkorrektur um etwa 85 % pro Korrekturschritt reduziert werden, wohingegen die Korrektur mittels spanenden Materialabtrags in der Regel lediglich einen Effekt von höchstens 50 % pro Korrekturschritt erwirkt. Dies reduziert die Anzahl erforderlicher Korrekturschritte bzw. führt bei gleicher Anzahl von Korrekturschritten zu einem besseren Ergebnis.

Mittels eines Lasers kann gezielt sehr wenig Material abgetragen werden oder besonders kleine Formen im Mikrometerbereich aus dem Material ausgearbeitet werden, was mittels der üblichen Verfahren nicht realisierbar ist. So kann z.B. durch das erfindungsgemäße Verfahren ein Kraftmesskörper so hergestellt werden, dass er eine hohe Unempfindlichkeit gegen außermittige Belastung aufweist.

Darüber hinaus können beim Fräsen oder Bohren, den üblichen Techniken zur Erstbearbeitung des Kraftmesskörper-Rohlings, entstandene harte Oberflächenschichten abgetragen werden, die die Biegsamkeit der Gelenkstelle nachteilig verändern. Gleichzeitig entstehen bei einem Materialabtrag mittels eines Lasers keine weiteren nachteiligen Veränderungen der nicht abgetragenen Materialstruktur, da ein Laser so gezielt auf den abzutragenden Materialbereich ausrichtbar ist, dass das umgebende Material keinerlei Veränderungen durch z.B. eine erhöhte Temperaturzufuhr erfährt. Auch entstehen bei der Gelenkstellengeometriekorrektur mittels Lasers keine Materialspäne die die zu diesem Zeitpunkt in der Regel bereits mit etlichen Anbaukomponenten, wie z.B. einer elektromagnetischen Spulenanordnung zur Kraftkompensation, ausgestattete Kraftmessvorrichtung funktionsbeeinträchtigend verschmutzen könnten und daher aufwändig entfernt werden müssten.

Weiterhin lassen sich allgemein Fräsabweichungen sowie Umschlagfehler in Gelenkstellen ausgleichen. Ein weiterer Vorteil der Lasergelenkstellenkorrektur ist, dass der Materialabtrag kräftefrei erfolgt. Mit anderen Worten, es wird keine zusätzliche Kraft auf die Gelenkstelle ausgeübt, welche diese plastisch verformt. Zudem findet bei einem Laser keine Abnutzung des Werkzeugs statt, was der Reproduzierbarkeit bei der Herstellung von Korrekturformen zugutekommt.

Die bei dem erfindungsgemäßen Verfahren verwendete Korrekturform ist grundsätzlich beliebig und kann jeweils den Erfordernissen des Einzelfalls angepasst werden. So sind z.B. eine punktförmige Vertiefung oder Gräben mit senkrechter Vertiefungskante vorstellbar. Schlussendlich können durch die verbesserte Qualität der Korrektur der Gelenkstellengeometrie eines Kraftmesskörpers mittels Lasers die Fehlproduktion solcher Kraftmesskörper erheblich eingeschränkt und somit Herstellungsaufwand und -kosten reduziert werden. Bei automatisierter Verfahrensdurchführung ist das erfindungsgemäße Verfahren zudem wenig zeitintensiv.

Bei einer besonderen Ausführungsform der Erfindung weist die korrigierte Gelenkstelle einen Bereich paralleler Oberflächen auf. Mit anderen Worten, die Oberfläche der einen Seite der Gelenkstelle liegt in einer Ebene, die parallel zu der Ebene der Oberfläche der gegenüberliegenden Seite der Gelenkstelle ist. Durch eine solche Form der Gelenkstelle, lassen sich die beiden entstandenen Teilbereiche des Kraftmesskörpers, im Vergleich zu einer Gelenkstelle derselben Größenordnung ohne parallelen Bereich, sehr leicht durch eine bereits geringe äußere Krafteinwirkung relativ zueinander auslenken. Diese hohe Empfindlichkeit der Gelenkstelle hat zur Folge, dass sich mit einer entsprechend ausgestalteten Kraftmessvorrichtung eine äußere Krafteinwirkung mit hoher Präzision bestimmen lässt.

In einer weiteren Ausführungsform weist die korrigierte Gelenkstelle wenigstens einen Schlitz auf, welcher die Gelenkstelle in mindestens zwei stegartige Gelenkstellenbereiche unterteilt. Mit einer solchen Mehrfachgelenkstelle kann die Elastizität der Gelenkstelle mit Schlitzen gegenüber einer Gelenkstelle derselben Ausgestaltung aber ohne Schlitz erhöht werden.

Darüber hinaus sind alle denkbaren Formen einer Gelenkstelle aufgrund der hohen Formgenauigkeit des Materialabtrags mittels eines Lasers möglich. Dies ist insbesondere deswegen besonders vorteilig, weil die Form der Gelenkstelle entsprechend den Anforderungen an die Teilbereiche und die Biegsamkeit zwischen den Teilbereichen gewählt werden kann.

Ein Merkmal einer weiteren erfindungsgemäßen Ausführungsform ist, dass die Korrekturform durch eine geschlossene mathematische Formel darstellbar ist. Dies hat zum Vorteil, dass sich die Menge des abzutragenden Materials leicht bestimmen lässt und damit die Korrektur der Gelenkstellengeometrie durch den gezielten Materialabtrag vereinfacht. Des Weiteren ist eine Form, welche durch eine geschlossene mathematische Formel darstellbar ist, maschinell leichter reproduzierbar und produzierbar als eine willkürliche Form.

In einer weiteren bevorzugten Ausführungsform ist einer der auslenkbaren Teilbereiche des Kraftmesskörpers ein Hebelarm. Mittels eines solchen Hebelarms kann die äußere Krafteinwirkung zu einem Sensor hin kraft- oder wegverstärkt gemessen werden. Daher ist es besonders wichtig, dass die Auslenkungsrichtung des Hebelarms nicht durch eine fehlerhafte Gelenkstelle beeinflusst wird. Dies würde eine Verfälschung des Messwertes für die äußere Krafteinwirkung zur Folge haben. Die mittels des Lasers erzielte Formgenauigkeit von solchen Gelenkstellen ist also besonders wichtig.

Ein Merkmal einer weiteren bevorzugten Ausführungsform ist, dass die Gelenkstellenkorrektur iterativ mittels einer automatischen Anlage durchgeführt wird. Da ein einziger Korrekturschritt der Gelenkstellengeometrie einen Fehler nicht zwingend vollständig behebt, werden mehrere solcher Korrekturschritte hintereinander ausgeführt. Bei diesem iterativen Verfahren wird die Gelenkstelle nach jedem Korrekturschritt erneut der Überprüfung ihres Auslenkungsverhaltens unterzogen und ihre Geometrie gegebenenfalls in einem nächsten Korrekturschritt erneut korrigiert. Dabei wird der Fehler der außermittigen Belastung bei jedem Korrekturschritt verringert bis er vernachlässigbar klein ist.

Ein erfindungsgemäßer Kraftmesskörper zeichnet sich in Verbindung mit den Merkmalen des Oberbegriffs von Anspruch 7 dadurch aus, dass die Korrekturstelle mittels Materialabtrags durch Laserbearbeitung erzeugt wurde. Der Fachmann wird die dabei entstehenden, lasertypischen Strukturmerkmale ohne weiteres erkennen und insbesondere gegen die bei herkömmlicher, spanender Bearbeitung entstehenden Strukturmerkmale abgrenzen können. Ein erfindungsgemäßer Kraftmesskörper wird sich vor allem durch eine besonders präzise Einhaltung der Herstellungsspezifikationen in Bezug auf das Auslenkungsverhalten seiner Gelenkstellen auszeichnen und den Bau besonders präziser Kraftmessvorrichtungen gestatten.

Weitere Merkmale und Vorteile der Erfindung ergeben sich aus der nachfolgenden speziellen Beschreibung und den Zeichnungen.

### Kurzbeschreibung der Zeichnungen

Es zeigen:
- Figur 1:: eine Ausführungsform des Kraftmesskörpers, welcher zwei durch eine Gelenkstelle separierte Teilbereiche aufweist. Hierbei zeigt a) eine Ausführungsform ohne äußere Krafteinwirkung, b) eine Ausführungsform des Kraftmesskörpers mit äußerer Krafteinwirkung und einer zur Biegeebene parallelen Auslenkungsrichtung, c) eine Ausführungsform des Kraftmesskörpers mit äußerer Krafteinwirkung und einer zur Biegeebene nicht parallelen Auslenkungsrichtung eines Teilbereichs,
- Figur 2:: zwei durch eine Gelenkstelle separierte Teilbereiche, wobei die Gelenkstelle
a) eine Gelenkstellenkorrektur mit Doppelgraben und parallelem Bereich aufweist,
b) eine flache Vertiefung aufweist,
c) eine gleichmäßig abgerundete Vertiefung aufweist, die eine ovale Form hat,
d) eine kreisförmige Gelenkstellenkorrektur aufweist,
- Figur 3:: eine Ausführungsform einer
a) bikonkaven Gelenkstelle,
b) Mehrfachgelenkstelle, welche als Doppelgelenkstelle ausgeführt ist,
c) bikonvexen Gelenkstelle,
d) Gelenkstelle mit parallelem Bereich,
e) Gelenkstelle mit zwei gerundeten Nuten,
- Figur 4:: eine Ausführungsform eines beispielhaften Verfahrensablaufs zur Gelenkstellenkorrektur eines Kraftmesskörpers.

### Ausführliche Beschreibung bevorzugter Ausführungsformen

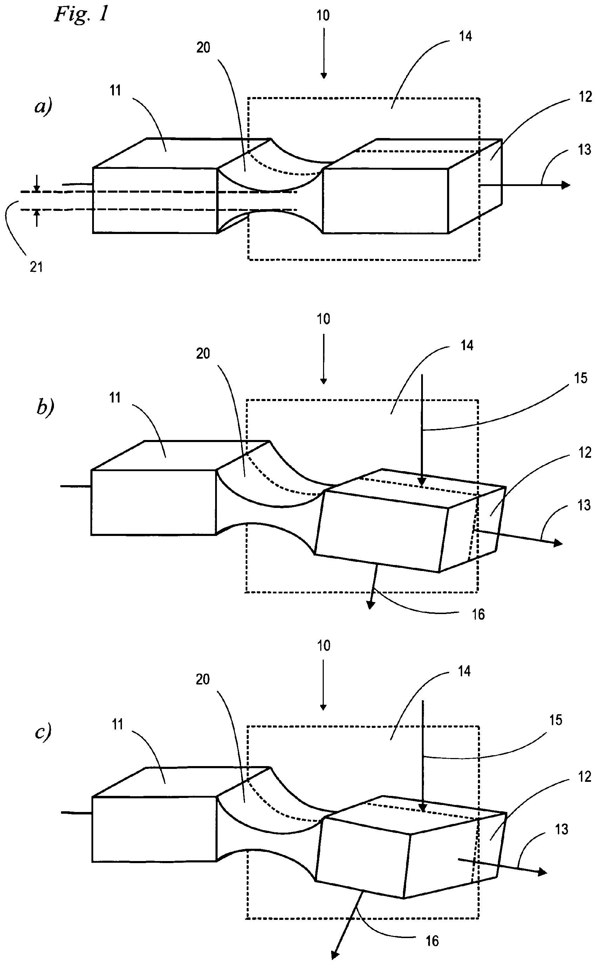

Figur 1 zeigt einen Kraftmesskörper 10, welcher durch eine Gelenkstelle 20 in zwei Teilbereiche 11, 12 separiert ist. In Figur 1a) liegt die Körperachse 13 ohne äußere Krafteinwirkung 15 (fehlt in Figur 1a) in der Biegeebene 14 der Gelenkstelle 20. Figur 1b) zeigt eine Ausführungsform des Kraftmesskörpers 10, wobei eine äußere Krafteinwirkung 15 auf einen Teilbereich 12 wirkt. Die Geometrie der Gelenkstelle 20 ist so ausgeführt, dass bei einer Richtung der äußeren Krafteinwirkung 15, die in der Biegeebene 14 liegt, die Auslenkungsrichtung 16 des Teilbereichs 12 ebenfalls in der Biegeebene 14 ist. Eine solche Gelenkstellengeometrie ist fehlerfrei ausgearbeitet und benötigt keine Korrektur, sofern die Dicke und die Position der Gelenkstelle und somit deren Beweglichkeit spezifikationsgemäß ist. Figur 1c) zeigt eine Ausführungsform eines Kraftmesskörpers 10 mit einer zu korrigierenden Gelenkstellengeometrie. Der durch die äußere Krafteinwirkung 15 ausgelenkte Teilbereich 12 besitzt eine Auslenkungsrichtung 16 die nicht parallel zur Biegeebene 14 ist. Des Weiteren ist auch seine Körperachse 13 nicht in der Biegeebene 14. Eine solche Gelenkstellengeometrie muss daher so korrigiert werden, dass die Auslenkungsrichtung 16 des Teilbereichs 12 bei äußerer Krafteinwirkung 15 in der Biegeebene 14 liegt. Ein derartiges Auslenkungsverhalten ist in der Regel unerwünscht, lässt sich jedoch durch Materialabtrag geeigneter Form und Größe, erfindungsgemäß durch Materialabtrag mittels Laserbearbeitung korrigieren.

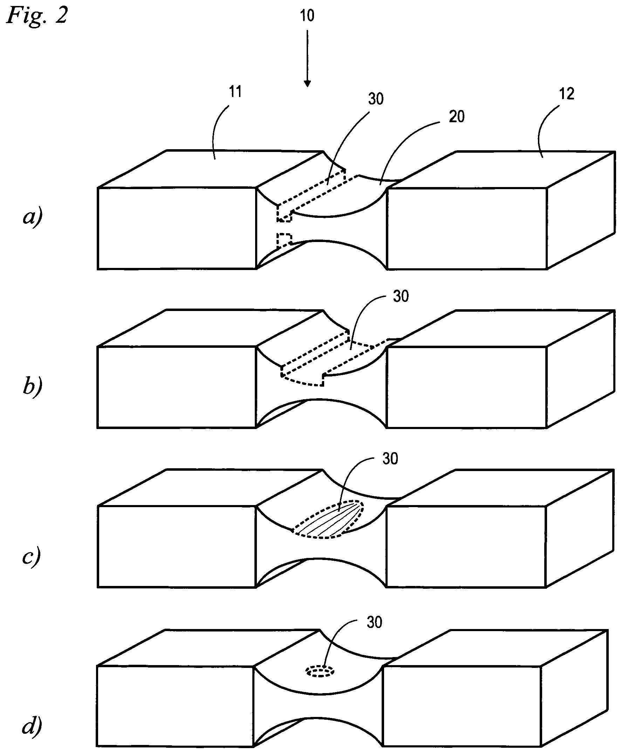

Figur 2 zeigt eine Ausführungsform eines Kraftmesskörpers 10 mit einer Gelenkstelle 20, welche zwei Teilbereiche 11, 12 des Kraftmesskörpers 10 voneinander separiert. Die hier ausgeführte bikonkave Gelenkstellengeometrie wurde mittels eines Lasers und anhand einer zuvor ermittelten Korrekturform 30 korrigiert. Hierbei zeigt a) eine Korrekturform, welche einen Doppelgraben mit zueinander parallelen Bereichen aufweist, b) eine Korrekturform 30 mit zur Gelenkstellenoberfläche senkrechten Vertiefungen und einer gleichmäßig flachen Vertiefungsebene, c) eine in die Tiefe gewölbte Vertiefung, die an ihrer Oberfläche eine halbovale Form aufweist, und d) eine punktförmige bzw. kreisförmige Korrekturform, welche die Gelenkstelle 20 teilweise oder ganz durchsetzen kann. Solche Korrekturformen 30 der Gelenkstellengeometrie ändern das Auslenkungsverhalten der beiden Teilbereiche 11, 12 des Kraftmesskörpers 10 unterschiedlich. So kann einerseits die Beweglichkeit vergrößert werden alternativ oder zusätzlich aber auch die Auslenkungsrichtung 16 des Teilbereichs 12 und/oder die exakte Position des Drehpunktes verändert werden. Somit kann ein Drall oder eine vertikale Neigungsempfindlichkeit des Teilbereichs 12 behoben werden und eine durch eine äußere Krafteinwirkung 15 hervorgerufene Auslenkungsrichtung 16, welche parallel zur Biegeebene 14 ist, erlangt werden.

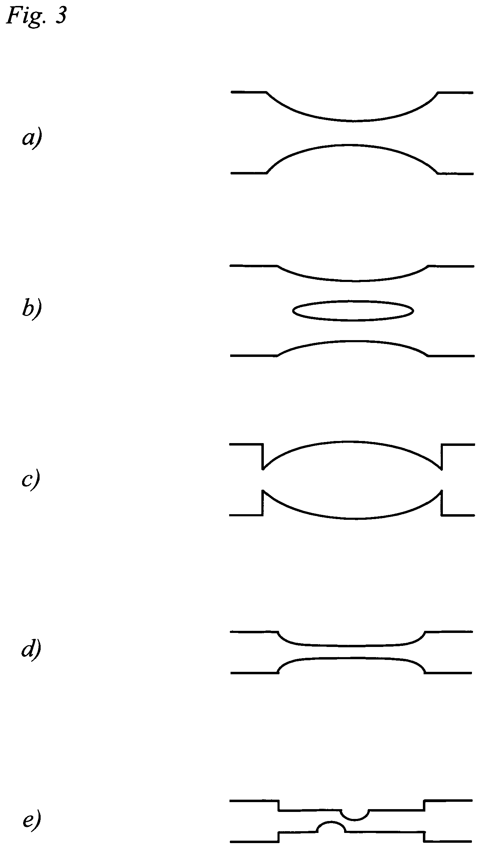

Figur 3 zeigt verschiedene Ausführungsformen einer Gelenkstelle, die mittels eines Lasers erzeugt oder korrigiert wurde. So zeigen a) eine bikonkave Gelenkstelle, b) eine Mehrfachgelenkstelle, welche als Doppelgelenkstelle aufgeführt ist, c) eine bikonvexe Gelenkstelle, d) eine Gelenkstelle mit parallelem Bereich und e) eine Gelenkstelle, mit zwei gerundeten Nuten.

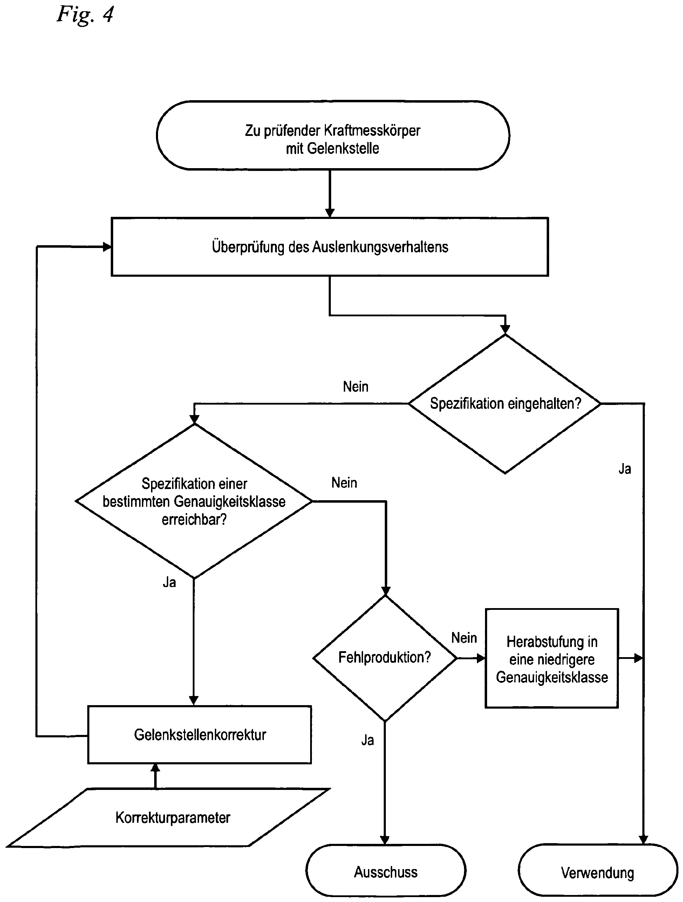

Figur 4 zeigt ein Verfahrensschema zur Überprüfung eines Kraftmesskörpers 10 für Kraftmesssysteme, welches eine Korrektur der Gelenkstellengeometrie beinhaltet. In einem ersten, hier nicht eingezeichneten Verfahrensschritt, wird an einem Kraftmesskörper 10 eine Gelenkstelle 20 mittels spanenden Materialabtrags hergestellt, sodass die Gelenkstelle 20 zwei Teilbereiche 11, 12 des Kraftmesskörpers 10 voneinander separiert. In einem zweiten Verfahrensschritt wird der Kraftmesskörper 10 mit einer Gelenkstelle 20 einer Überprüfung des Auslenkungsverhaltens unterzogen. Die ermittelten Messwerte werden mit einer gegebenen Spezifikation verglichen und es wird überprüft, ob diese Spezifikation eingehalten worden ist oder nicht. Im ersteren Fall ist der Kraftmesskörper 10 korrekt ausgeführt und kann direkt verwendet werden. Im letzteren Fall wird in einem nächsten Verfahrensschritt geprüft, ob eine Gelenkstellenkorrektur den gemessenen Fehler des Kraftmesskörpers 10 ausgleichen kann. Ist die Spezifikation einer bestimmten Genauigkeitsklasse des Kraftmesskörpers 10 mittels einer Gelenkstellenkorrektur erreichbar, so wird eine solche Gelenkstellenkorrektur in einem nächsten Verfahrensschritt durchgeführt. Hierbei werden die zuvor ermittelten Abweichungen des Auslenkungsverhaltens des Kraftmesskörpers 10 von der Datenspezifikation in Korrekturparameter umgewandelt, sodass eine geeignete Korrekturform ermittelt und an der Gelenkstelle 20 angewendet werden kann. Ist das Ergebnis der Abschätzung der Erfolgsaussichten einer Korrektur jedoch, dass diese die Fehler nicht hinreichend reduzieren oder beseitigen kann, so wird in einem nächsten Verfahrensschritt geprüft, ob der Kraftmesskörper 10 in eine niedrigere Genauigkeitsklasse eingestuft werden kann oder ob die Fehler so gravierend sind, dass er als Fehlproduktion zur Ausschussware eingeordnet wird. Anhand eines solchen Korrekturverfahrens kann also die Fehlproduktion und damit die Herstellungskosten von Kraftmesskörpern reduziert werden.

### Bezugszeichenliste

- 10: Kraftmesskörper
- 11: erster Teilbereich des Kraftmesskörpers
- 12: zweiter Teilbereich des Kraftmesskörpers
- 13: Körperachse
- 14: Biegeebene
- 15: Richtung der äußeren Krafteinwirkung
- 16: Auslenkungsrichtung
- 20: Gelenkstelle
- 21: Dicke der Gelenkstelle
- 30: Korrekturform

## Patentansprüche

1. Verfahren zur Fertigung eines Kraftmesskörpers (10) mit mindestens einer Gelenkstelle (20), die einen Bereich des Kraftmesskörpers (10) in zwei zueinander auslenkbare, verbundene Teilbereiche (11, 12) separiert, wobei folgende Schritte ausgeführt werden:
a) Bereitstellen eines Kraftmesskörper-Rohlings (10),
b) spanender Materialabtrag am Kraftmesskörper-Rohling (10) zur Herstellung der Gelenkstelle (20),
c) Überprüfung, ob das durch die Gelenkstelle erzeugte Auslenkungsverhalten der Teilbereiche (11, 12) der Spezifikation einer vorgegebenen Genauigkeitsklasse entspricht oder von ihr abweicht, wobei
c1) sofern das Auslenkungsverhalten der vorgegebenen Spezifikation entspricht, das Verfahren beendet wird, und
c2) sofern das Auslenkungsverhalten von der vorgegebenen Spezifikation abweicht, Schritt d ausgeführt wird,
d) Überprüfung, ob die Abweichung mittels einer Gelenkstellenkorrektur ausgleichbar ist, wobei
d1) sofern sie ausgleichbar ist, die Schritte e bis g ausgeführt werden, und
d2) sofern sie nicht ausgleichbar ist, Schritt h ausgeführt wird,
e) Bestimmung einer mittels Materialabtrags herstellbaren Korrekturform (30), die die Abweichung von der vorgegebenen Spezifikation ausgleicht,
f) Korrektur der Gelenkstellengeometrie anhand der im vorigen Verfahrensschritt bestimmten Korrekturform (30) mittels Materialabtrags durch einen Laser,
g) erneutes Ausführen von Verfahrensschritt c,
h) Überprüfung, ob das Auslenkverhalten der Spezifikation einer niedrigeren Genauigkeitsklasse entspricht oder von ihr abweicht, wobei
h1) sofern das Auslenkverhalten der niedrigeren Spezifikation entspricht, der Kraftmesskörper (10) in die niedrigere Genauigkeitsklasse eingestuft und das Verfahren beendet wird, und
h2) sofern das Auslenkverhalten von der niedrigeren Spezifikation abweicht, der Kraftmesskörper (10) als Fehlproduktion eingeordnet und das Verfahren beendet wird.

## Claims

1. Method of making a force measuring body (10) with at least one joint location (20) which separates a region of the force measuring body (10) into two connected sub-regions (11, 12) deflectable relative to one another, wherein the following steps are performed:
a) providing a force measuring body blank (10),
b) removal of material at the force measuring body blank (10) by cutting so as to produce the joint location (20),
c) checking whether the deflection behaviour, which is produced by the joint location, of the sub-regions (11, 12) corresponds with or deviates from the specification of a predetermined category of accuracy, wherein
c1) the method is ended if the deflection behaviour corresponds with the predetermined specification and
c2) step d) is carried out if the deflection behaviour deviates from the predetermined specification,
d) checking whether compensation for the deviation can be provided by means of a joint location correction, wherein
d1) the steps e) to g) are carried out if compensation can be provided and
d2) step h) is carried out if compensation cannot be provided,
e) determining a form of correction (30) which is producible by removal of material and which compensates for the deviation from the predetermined specification,
f) correction of the joint location geometry on the basis of the form of correction (30), which was determined in the preceding method step, by means of removal of material by a laser,
g) repeated performance of method step c) and
h) checking whether the deflection behaviour corresponds with or deviates from the specification of a lower category of accuracy, wherein
h1) the force measuring body (10) is categorised in the lower accuracy category and the method is ended if the deflection behaviour corresponds with the lower specification and
h2) the force measuring body (10) is categorised as faulty production and the method is ended if the deflection behaviour deviates from the lower specification.

## Revendications

1. Procédé de fabrication d'un corps de mesure de forces (10) comportant au moins un point d'articulation (20) partageant une zone du corps de mesure de forces (10) en deux sous-zones (11, 12) raccordées, orientables l'une par rapport à l'autre, dans lequel les étapes suivantes sont exécutées :
a) préparation d'une ébauche de corps de mesure de forces (10),
b) enlèvement de matière par coupe sur l'ébauche de corps de mesure de forces (10) pour réaliser le point d'articulation (20),
c) contrôle si le comportement d'orientation des sous-zones (11, 12) créées par le point d'articulation satisfait à la spécification d'une classe de précision prescrite ou en diffère, dans lequel
c1) le procédé est terminé si le comportement d'orientation satisfait à la spécification définie, et
c2) l'étape d est exécutée si le comportement d'orientation diffère de la spécification définie,
d) contrôle si l'écart est compensable par une correction du point d'articulation, dans lequel
d1) si l'écart est compensable, exécution des étapes e à g, et
d2) si l'écart n'est pas compensable, exécution de l'étape h,
e) détermination d'une forme de correction (30) réalisable par enlèvement de matière, compensant l'écart par rapport à la spécification définie,
f) correction de la géométrie de point d'articulation sur la base de la forme de correction (30), par enlèvement de matière au moyen d'un laser déterminée à l'étape précédente,
g) ré-exécution de l'étape c,
h) contrôle si le comportement d'orientation satisfait à la spécification d'une classe de précision inférieure ou en diffère, dans lequel
h1) le corps de mesure de forces (10) est classé dans la classe de précision inférieure et le procédé est terminé si le comportement d'orientation satisfait à la spécification inférieure, et
h2) le corps de mesure de forces (10) est classé en tant que produit défectueux et le procédé est terminé si le comportement d'orientation diffère de la spécification inférieure.
